# EUROPÄISCHE PATENTSCHRIFT

(11) **EP 3 352 236 B1**
(45) Veröffentlichungstag und Bekanntmachung des Hinweises auf die Patenterteilung: **03.11.2021**
(21) Anmeldenummer: 18151163.5
(22) Anmeldetag: 11.01.2018
(51) Int. Cl.: H01L 39/24, B22F 10/20

(54) **VERFAHREN ZUR FERTIGUNG EINER ZUMINDEST ZWEITEILIGEN STRUKTUR, INSBESONDERE EINES HALBZEUGS FÜR EINEN SUPRALEITERDRAHT**
METHOD OF MANUFACTURING A STRUCTURE WITH AT LEAST TWO PARTS, IN PARTICULAR A SEMI-FINISHED PRODUCT FOR A SUPERCONDUCTING WIRE
PROCÉDÉ DE FABRICATION D'UNE STRUCTURE RÉALISÉE EN AU MOINS DEUX PARTIES, EN PARTICULIER D'UN DEMI-PRODUIT POUR UN FIL SUPRACONDUCTEUR

(30) Priorität: 23.01.2017 DE 102017201035
(43) Veröffentlichungstag der Anmeldung: 25.07.2018
(73) Patentinhaber: Bruker EAS GmbH, 63450 Hanau (DE)
(72) Erfinder: Schlenga, Klaus, 76149 Karlsruhe (DE); Abächerli, Vital, 63526 Erlensee (DE); Sailer, Bernd, 63755 Alzenau (DE); Thöner, Manfred, 63599 Biebergemünd (DE); Wanior, Matheus, 63571 Gelnhausen (DE)
(74) Vertreter: Kohler Schmid Möbus Patentanwälte

(56) Entgegenhaltungen:
- EP-A2- 1 800 700
- DE-A1- 1 483 365
- DE-U1-202012 102 334
- JP-A- 2000 190 086
- US-A1- 2018 043 437
- US-B1- 9 023 765

## Beschreibung

Die Erfindung betrifft ein Verfahren zur Fertigung einer zumindest zweiteiligen Struktur, insbesondere eines Halbzeugs für einen Supraleiterdraht,
wobei eine erste Struktur und eine zweite Struktur separat gefertigt werden, und anschließend die erste Struktur und die zweite Struktur ineinander gefügt werden.

Supraleiterdrähte, wie beispielsweise NbTi-Supraleiterdrähte, werden dazu eingesetzt, große elektrische Ströme praktisch verlustfrei zu führen, insbesondere in supraleitenden Magnetspulen zur Erzeugung starker Magnetfelder. NbTi hat dabei den Vorteil einer guten Duktilität, was die Verarbeitung des Materials erleichtert; insbesondere sind plastische Umformungen gut möglich.

Supraleitende Materialien wie NbTi sind dabei nur unterhalb einer kritischen Temperatur (auch Sprungtemperatur genannt) supraleitend und müssen daher im Betrieb gekühlt werden, beispielsweise mit flüssigem Helium. In vielen Anwendungen sind Filamente aus supraleitendem Material vorgesehen, die in einer normalleitenden Matrix, oft aus Kupfer, angeordnet sind. Das Matrixmaterial sollte eine gute Wärmeleitfähigkeit aufweisen, so dass die Kühlung der supraleitenden Filamente gewährleistet ist, und auch eine gute elektrische Leitfähigkeit (bei der Sprungtemperatur) aufweisen, so dass im Falle eines lokalen Verlust der Supraleitung (Quench) ein Ersatzstrompfad zur Verfügung steht, um den Supraleiterdraht vor einem Durchbrennen zu schützen.

Zur Einbringung supraleitender Filamente in eine Matrix ist es bekannt, in einen tieflochgebohrten Block aus dem Matrixmaterial (etwa aus Kupfer) ein oder mehrere stabartige Elemente aus NbTi (oder enthaltend NbTi) einzubringen, vgl. beispielsweise die DE 20 2012 102 334 U1. Der befüllte Matrixblock, der auch als ein Halbzeug bezeichnet werden kann, wird schließlich zu einem Draht gezogen, üblicherweise nach einem weiteren Verbauen und einem oder mehreren Zwischenbündelungsschritten.

Tieflochbohren wird für engere und tiefere Bohrungen immer schwieriger, so dass im Allgemeinen ein mehrfaches Bündeln und Ziehen erforderlich ist, um supraleitende Filamente in der gewünschten Anzahl und mit dem gewünschten Durchmesser in einem Supraleiterdraht anzuordnen. Dies bedeutet einen erheblichen Aufwand bei der Fertigung.

Eine Besonderheit bei der Bereitstellung von NbTi-haltigen Elementen ist zudem das Erfordernis einer schnellen Abkühlung bei der Herstellung der NbTi-haltigen Elemente, um die Bildung einer unerwünschten α-Phase zu vermeiden. Durch Abschrecken kann eine besser duktile β-Phase eingefroren werden, was aber die NbTi-haltigen Elemente teuer macht.

Zur Herstellung von metallischen Bauteilen anhand von CAD-Daten ist es bekannt geworden, ein Bauteil in Schichten durch lokales Aufschmelzen eines Metallpulvers mit einem Laserstrahl oder Elektronenstrahl zu fertigen ("Selektives Laserschmelzen" bzw. "Selektives Elektronenstrahlschmelzen"), vgl. beispielsweise die Internetseite http://netzkonstrukteur.de/fertigungstechnik/3d-druck/selektiveslaserschmelzen/ aufgerufen am 6.7.2016, oder auch die Internetseite http.//netzkonstrukteur.de/fertigungstechnik/3d-druck/selektiveselektronenstrahlschmelzen/ aufgerufen am 22.11.2016. Die Fertigungsmethode benötigt keine Negativ-Formen und ermöglicht Hinterschnitte.

Aus der EP 1 800 700 A2 ist es bekannt geworden, ein Metallimplantat mit einer Knocheneinwachs-Struktur, einer Lagerstütz-Struktur und einer Zwischen-Struktur zu fertigen. Auf der Lagerstütz-Struktur ist eine Lagerfläche angeordnet. Die Knocheneinwachs-Struktur, die Lagerstütz-Struktur und die Zwischen-Struktur können mittels eines Laser-Aufschmelzprozesses gefertigt werden. Die Lagerfläche kann aus einem Polymer, einem metallischen Material oder einem keramischen Material gefertigt sein. Wenn die Lagerfläche aus einem metallischen Material gefertigt ist, kann dafür ein selektiver Laserschmelzprozess eingesetzt werden.

### Aufgabe der Erfindung

Der Erfindung liegt die Aufgabe zugrunde, die Fertigung von zweiteiligen Strukturen, insbesondere für Halbzeuge von Supraleiterdrähten, zu vereinfachen.

### Kurze Beschreibung der Erfindung

Diese Aufgabe wird gelöst durch ein Verfahren zur Fertigung einer zumindest zweiteiligen Struktur, insbesondere eines Halbzeugs für einen Supraleiterdraht, wobei eine erste Struktur und eine zweite Struktur separat gefertigt werden, und anschließend die erste Struktur und die zweite Struktur ineinander gefügt werden,
wobei die erste Struktur und die zweite Struktur jeweils schichtweise durch selektives Laserschmelzen oder selektives Elektronenstrahlschmelzen eines Pulvers gefertigt werden,
und wobei die erste Struktur mit einer Vielzahl von axialen Ausnehmungen gefertigt wird, und die zweite Struktur mit einer Vielzahl von gegengleichen, axialen Fortsätzen gefertigt wird.

Durch die schichtweise Fertigung der beiden (Teil-)Strukturen jeweils durch selektives Laserschmelzen oder selektives Elektronenstrahlschmelzen ist es möglich, hohe Aspektverhältnisse in einer oder bevorzugt beiden Strukturen anzuwenden, die durch mechanische Verfahren wie Tieflochbohren oder Abdrehen nicht oder nur sehr schwer möglich wären.

Zudem werden die zumindest zwei Strukturen erst nach ihrer jeweiligen Einzelfertigung zusammengefügt, so dass während eines jeweiligen Fertigungsprozesses einer Struktur nur ein Pulvermaterial gleichzeitig benötigt bzw. verarbeitet wird; dies vermeidet Querkontaminationen der Materialien von erster und zweiter Struktur. Die zusammengefügte Gesamt-Struktur kann dann aber problemlos mehrere verschiedene Materialien, nämlich die Materialien der ersten Struktur und zweiten Struktur und ggf. weiterer (Teil-)Strukturen kombinieren. Dadurch ist es möglich, Gesamt-Strukturen, wie sie für Halbzeuge von elektrischen Leiterdrähten, insbesondere Supraleiterdrähten, benötigt werden, auf einfache Weise zu fertigen.

Insbesondere können NbTi-Elemente (als zweite Struktur oder Teile einer zweiten Struktur) in einen Cu-Block (als erste Struktur) eingebracht werden, wobei durch ein hohes Aspektverhältnis (und mit ausreichend vielen NbTi-Elementen der zweiten Struktur) die Anzahl von Zwischenbündelungsschritten bis zum fertigen NbTi-haltigen Supraleiterdraht verringert werden kann. Durch die separate Fertigung von erster und zweiter Struktur kann ein Einbringen (Kontamination) von NbTi in den Cu-Block in der Regel problemlos vermieden werden, wodurch ein hohes Restwiderstandsverhältnis (RRR) in der Cu-Phase sichergestellt werden kann. Zudem geht die schichtweise Fertigung durch Laserschmelzen oder Elektronenstrahlschmelzen grundsätzlich mit einer vergleichsweise schnellen Materialabkühlung einher, so dass im Materialsystem NbTi die Bildung der unerwünschten α-Phase inhärent (also ohne Zusatzaufwand bzw. Zusatzkosten) vermieden wird.

Man beachte, dass die Erfindung auch für andere Materialsysteme, insbesondere auch nicht supraleitende Verbundsysteme (etwa Al/Cu) eingesetzt werden kann.

Typischerweise wird die erste Struktur in einem ersten 3D-Drucker (einer ersten Apparatur), und die zweite Struktur in einem zweiten 3D-Drucker (einer zweiten Apparatur) gefertigt, falls gewünscht auch parallel (zeitgleich) zueinander. Alternativ können auch die erste Struktur und die zweite Struktur hintereinander in demselben 3D-Drucker (Apparatur) gefertigt werden. Ebenso ist es möglich, die erste Struktur mit selektivem Laserschmelzen und die zweite Struktur mit selektivem Elektronenstrahlschmelzen zu fertigen, oder umgekehrt.

Die erste Struktur und die zweite Struktur verhalten sich typischerweise wie Positiv und Negativ zueinander, so dass nach dem Zusammenfügen (bis auf das für ein ineinander Einfügen notwenige Spiel) keine Hohlräume im Inneren verbleiben. Alternativ können auch noch weitere Teilstrukturen (zusätzlich zu erster und zweiter Struktur) zur Gesamt-Struktur zusammengesetzt werden, typischerweise so dass wiederum keine Hohlräume verbleiben. Das ineinander Einfügen erfolgt typischerweise durch ineinander Schieben entlang einer axialen Richtung.

Gemäß der Erfindung ist vorgesehen, dass die erste Struktur mit einer Vielzahl von axialen Ausnehmungen gefertigt wird, und die zweite Struktur mit einer Vielzahl von gegengleichen, axialen Fortsätzen gefertigt wird. Dadurch ist es möglich, in axialer Richtung ausgedehnte Zonen (Unterstrukturen) mit anderen Eigenschaften als eine umgebende Matrix zu fertigen, insbesondere bei hohen Aspektverhältnissen. Die axialen Fortsätze können insbesondere als supraleitende Filamente in einer normalleitenden Matrix verwendet werden. Die Ausnehmungen bzw. Fortsätze durchziehen typischerweise die gesamte axiale Länge der jeweiligen Struktur, ggf. mit Ausnahme einer Endplatte.

Das schichtweise Herstellen einer Struktur durch selektives Laserschmelzen oder selektives Elektronenstrahlschmelzen ist im Rahmen der additiven Fertigung (additive manufacturing) bzw. 3D-Druck bekannt geworden. In jeder Schicht wird dabei jeweils ein Bereich vorgesehen, der vom Laserstrahl bzw. Elektronenstrahl überstrichen wird und dadurch lokal aufgeschmolzen wird, sodass dort die Pulverkörner miteinander verbunden werden ("laserbestrahlter Bereich" bzw. "elektronenstrahlbestrahlter Bereich", auch kurz bezeichnet als "bestrahlter Bereich"). Der laserbestrahlte bzw. elektronenstrahlbestrahlte Bereich kann dabei auch mehrere unverbundene Teilbereiche umfassen. Zudem wird in der Regel auch ein anderer Bereich einer jeweiligen Schicht nicht vom Laserstrahl bzw. Elektronenstrahl überstrichen, so dass dort die Pulverkörner unverbunden verbleiben ("unbestrahlter Bereich"). Der unbestrahlte Bereich kann dabei ebenfalls mehrere unverbundene Teilbereiche umfassen. In der Regel wird eine Vielzahl von Schichten nacheinander und aufeinander gefertigt, meist 100 Schichten oder mehr, wobei in jeder Schicht der jeweilige dortige, laserbestrahlte bzw. elektronenstrahlbestrahlte Bereich verfestigt wird. Das verbleibende Pulver nach Fertigung aller Schichten wird entfernt, und die fertige Struktur wird erhalten.

Eine typische erste oder zweite Struktur hat typischerweise eine axiale Gesamtlänge zwischen 30 cm und 1,50 m, bevorzugt zwischen 50 cm und 1 m, und hat weiterhin typischerweise einen Gesamtdurchmesser zwischen 5 cm und 50 cm, bevorzugt zwischen 10 cm und 25 cm. Eine typische erste oder zweite Struktur weist typischerweise entlang einer axialen Richtung einen konstanten Außenquerschnitt auf (ggf. von einer Endplatte abgesehen, die typischerweise nach dem Ineinanderschieben entfernt wird).

### Bevorzugte Varianten der Erfindung

Bei einer bevorzugten Variante des erfindungsgemäßen Verfahrens werden die erste Struktur und die zweite Struktur aus unterschiedlichen Materialien gefertigt. Dadurch ist es auf einfache Weise möglich, eine Gesamt-Struktur zu erhalten, die mittels schichtweiser Fertigung durch Laserschmelzen bzw. Elektronenstrahlschmelzen hergestellt ist und dabei unterschiedliche Materialien kombiniert. Durch das Zusammenfügen nach der separaten Fertigung der beiden Strukturen können die beiden Materialien kombiniert werden, ohne dass zwei Pulvermaterialien gleichzeitig an einer einzigen Struktur schichtweise verarbeitet werden müssten. In dieser Ausführungsform sind die Pulver, aus denen die erste und die zweite Struktur gefertigt werden, entsprechend unterschiedlich zusammengesetzt; typischerweise enthält eines der Pulver ein Supraleitermaterial (oder die aufzuschmelzenden Komponenten dafür) und das andere Pulver enthält normalleitendes Material (oder die aufzuschmelzenden Komponenten dafür).

In einer vorteilhaften Variante wird die erste Struktur mit wenigstens 7, bevorzugt wenigstens 19, axialen Ausnehmungen und die zweite Struktur mit wenigstens 7, bevorzugt wenigstens 19, gegengleichen, axialen Fortsätzen gefertigt. In einer anderen Variante können auch wenigstens 6 Ausnehmungen bzw. Fortsätze vorgesehen sein. Durch eine große Zahl von Ausnehmungen bzw. Forstätzen wird die Fertigung besonders rationell; die Anzahl der Ausnehmungen bzw. Fortsätze verändert die Fertigungsdauer einer jeweiligen Schicht nicht oder nur unwesentlich. Typischerweise sind die axialen Ausnehmungen untereinander gleich, und die axialen Fortsätze untereinander gleich.

Besonders bevorzugt ist eine Variante, bei der die axialen Fortsätze der zweiten Struktur ein Fortsätze-Aspektverhältnis FAV von wenigstens 20 aufweisen. Das Fortsätze-Aspektverhältnis der zweiten Struktur wird beschrieben durch den Quotienten der axialen Länge geteilt durch den größten Durchmesser (quer zur axialen Richtung) eines Fortsatzes. Diese Aspektverhältnisse sind mit dem erfindungsgemäßen Verfahren leicht zu fertigen, im Gegensatz zu mechanischen Verfahren.

Ebenso besonders bevorzugt ist eine Variante, bei der ein axialer Stegebereich der ersten Struktur, in welchem die axialen Ausnehmungen ausgebildet sind, ein Stege-Aspektverhältnis SAV von wenigstens 20 aufweist. Das Stege-Aspektverhältnis wird beschrieben durch den Quotienten der axialen Länge des Stegebereichs geteilt durch den kleinsten Abstand ("Stegbreite") (quer zur axialen Richtung) benachbarter Ausnehmungen im Stegebereich, gemessen zwischen den gegenüberliegenden Begrenzungen der Ausnehmungen. Diese Aspektverhältnisse sind wiederum mit dem erfindungsgemäßen Verfahren leicht zu fertigen, im Gegensatz zu mechanischen Verfahren.

Bei einer bevorzugten Variante ist vorgesehen, dass die erste Struktur und die zweite Struktur schichtweise entlang einer Richtung senkrecht zur axialen Erstreckungsrichtung der axialen Ausnehmungen und der axialen Fortsätze gefertigt werden. Dadurch sind etwaige flächenhafte Fehler (etwa nicht supraleitende Flächen), die zwischen zwei Schichten eingebracht werden, parallel zur Längsrichtung und damit parallel zur üblichen Stromflussrichtung eines Leiterdrahts orientiert und haben daher nur einen geringen Einfluss auf die Stromtragfähigkeit. Entsprechend sind bei diesem Vorgehen besonders hohe Stromtragfähigkeiten eines fertigen Leiterdrahts, insbesondere Supraleiterdrahts, möglich. Man beachte, dass für diese Weiterbildung das pulverförmige Material und der Laserstrahl bzw. Elektronenstrahl über eine vergleichsweise große Strecke bzw. große Fertigungsfläche verteilt bzw. geführt werden muss; jedoch ist nur eine geringe Hubhöhe der Bauplattform erforderlich. Es ist auch möglich, unabhängig von axialen Fortsätzen und Ausnehmungen vorzusehen, die erste und zweite Struktur schichtweise senkrecht zur axialen Erstreckungsrichtung zu fertigen.

Bei einer alternativen Variante werden die erste Struktur und die zweite Struktur schichtweise entlang der axialen Erstreckungsrichtung der axialen Ausnehmungen und der axialen Fortsätze gefertigt. In diesem Fall kann eine vergleichsweise kleine Bauplattform eingesetzt werden. Es ist auch möglich, unabhängig von axialen Fortsätzen und Ausnehmungen vorzusehen, die erste und zweite Struktur schichtweise entlang der axialen Erstreckungsrichtung zu fertigen.

Bevorzugt ist auch eine Variante, bei die zweite Struktur ganz oder überwiegend aus einem supraleitenden Material, insbesondere aus NbTi, gefertigt wird. Die Supraleitermaterialien können unter sehr kontrollierten Bedingungen aufgeschmolzen und gewachsen werden; es sind hohe Stromtragfähigkeiten möglich, insbesondere als Filamente (Fortsätze). Als supraleitendes Material kommen in erster Linie metallische Supraleiter bzw. Tieftemperatursupraleiter in Betracht.

Bei einer alternativen Variante wird die zweite Struktur ganz oder überwiegend aus Aluminium oder Kupfer gefertigt. In dieser Variante können normalleitende Leiterstrukturen mit hoher Reinheit gefertigt werden, insbesondere als Filamente (Fortsätze).

Bevorzugt ist weiterhin eine Verfahrensvariante, bei der die erste Struktur ganz oder überwiegend aus Aluminium oder Kupfer gefertigt wird, oder dass die erste Struktur ganz oder überwiegend aus einer Legierung enthaltend Aluminium oder Kupfer gefertigt wird. Die erste Struktur kann hier als stabilisierende (normalleitende) Matrix in einem Supraleiterdraht oder in einer anderen Leiterstruktur dienen.

Vorteilhaft ist weiterhin eine Variante, bei der die zweiteilige Struktur nach dem ineinander Fügen einer querschnittsverjüngenden Umformung, insbesondere einem oder mehreren Kalt- und/oder Warmumformprozessen, unterzogen wird. Als Umformtechniken kommen insbesondere Strangpressen, Extrudieren, Walzen oder Drahtziehen in Betracht. Durch querschnittsverjüngende (querschnittsreduzierende) Umformung, ggf. auch mehrfach mit Zwischenbündelungen, können besonders zahlreiche und feine Unterstrukturen, insbesondere supraleitende Filamente, eingerichtet werden. Zudem kann durch die Umformung auch eine Verdichtung der Materialien erreicht werden.

Besonders bevorzugt ist eine Variante, bei der die erste Struktur und/oder die zweite Struktur nach dem schichtweisen Fertigen durch selektives Laserschmelzen oder selektives Elektronenstrahlschmelzen einer Oberflächenbehandlung, insbesondere einer rauhigkeitsreduzierenden Oberflächenbehandlung, bevorzugt Elektropolieren, unterzogen wird. Durch eine rauhigkeitsreduzierende Oberflächenbehandlung kann ein besserer gegenseitiger Kontakt der ersten und zweiten Struktur nach dem ineinander Fügen erreicht werden. Gegebenenfalls können Hohlräume zwischen der ersten und der zweiten Struktur reduziert oder verhindert werden. Durch Elektropolieren können auf einfache Weise Materialspitzen vorrangig entfernt werden. Ebenso ist es möglich, als Oberflächenbehandlung eine Beschichtung durchzuführen, beispielsweise über Elektroplattieren (Galvanisieren), insbesondere wenn erste und zweite Struktur aus dem gleichen Material bestehen. Falls gewünscht, können die erste und/oder die zweite Struktur nach dem Laserschmelzen oder Elektronenstrahlschmelzen ein Übermaß aufweisen, welches durch eine materialabtragende Oberflächenbehandlung beseitigt wird, und so das ineinander Fügen vorzubereiten bzw. zu ermöglichen. Ebenso ist es möglich, mit einer materialauftragenden Oberflächenbehandlung ein übermäßiges Spiel zwischen erster und zweiter Struktur zu reduzieren oder zu beseitigen, und so das ineinander Fügen vorzubereiten.

In den Rahmen der vorliegenden Erfindung fällt auch eine zumindest zweiteilige Struktur, insbesondere ein Halbzeug für einen Supraleiterdraht, hergestellt nach einem erfindungsgemäßen, obigen Verfahren. Die zumindest zweiteilige Struktur kann mit großen Aspektverhältnissen der enthaltenen Unterstrukturen schnell gefertigt werden, wobei auch verschiedene Materialien auf einfache Weise kombiniert werden können. Die zumindest zweiteilige Struktur kann als ein Leiterdraht (auch Supraleiterdraht) oder ein Halbzeug dafür ausgebildet sein.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

Die Erfindung ist in der Zeichnung dargestellt und wird anhand von Ausführungsbeispielen näher erläutert. Die nicht maßstabsgetreuen Abbildungen zeigen:
- Fig. 1: eine schematische Ansicht einer Apparatur zur schichtweisen Fertigung einer ersten und/oder zweiten Struktur mit selektivem Laserschmelzen eines Pulvers, im Rahmen der Erfindung;
- Fig. 2: eine schematische Schrägansicht einer beispielhaften, zweiten Struktur, gefertigt im Rahmen der Erfindung, mit hier sechs axialen Fortsätzen;
- Fig. 3: eine schematische Schrägansicht einer beispielhaften, ersten Struktur, gefertigt im Rahmen der Erfindung, mit hier sechs axialen Ausnehmungen, komplementär zur zweiten Struktur von Fig. 2;
- Fig. 4a-4f: einen schematischen Ablauf bei der Fertigung einer erfindungsgemäßen, zweiteiligen Struktur, mit
4a) erste und zweite Struktur nach der schichtweisen Fertigung mittels selektivem Laserschmelzen oder Elektronenstrahlschmelzen,
4b) Elektropolieren von erster und zweiter Struktur;
4c) Ineinander Fügen von erster und zweiter Struktur; 4d) die zweiteilige Struktur nach dem Ineinanderfügen;
4e) die zweiteilige Struktur nach dem Abschneiden der Endplatten;
4f) querschnittsverjüngende Umformung der zweiteiligen Struktur;

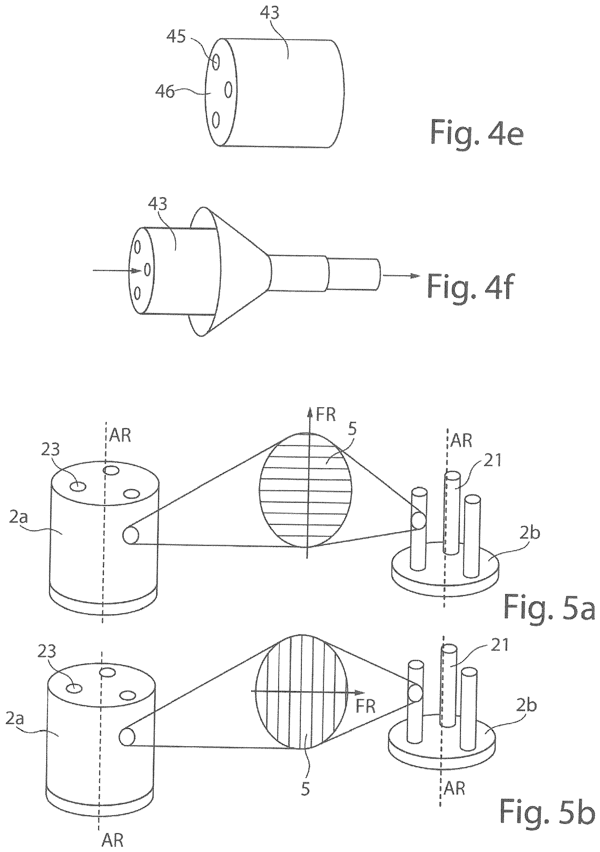

- Fig. 5a: eine schematische Illustration der Fertigungsrichtung von erster und zweiter Struktur entlang der axialen Erstreckungsrichtung;
- Fig. 5b: eine schematische Illustration der Fertigungsrichtung von erster und zweiter Struktur senkrecht zur axialen Erstreckungsrichtung;

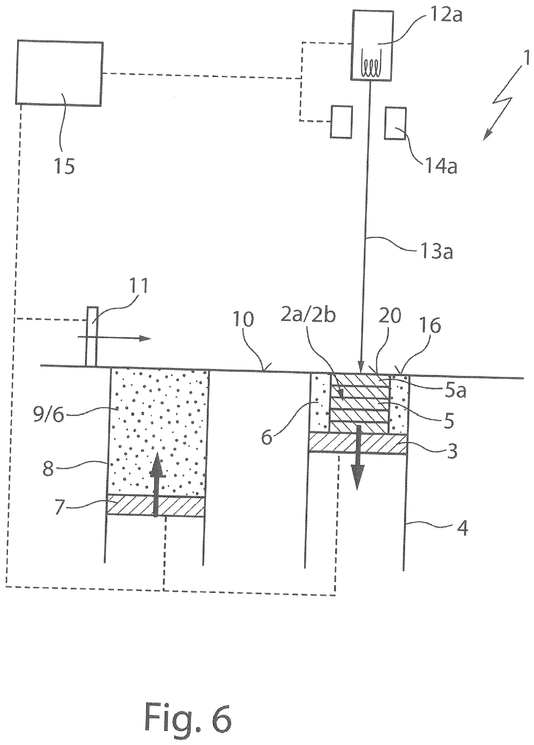

- Fig. 6: eine schematische Ansicht einer Apparatur zur schichtweisen Fertigung einer ersten und/oder zweiten Struktur mit selektivem Elektronenstrahlschmelzen eines Pulvers, im Rahmen der Erfindung.

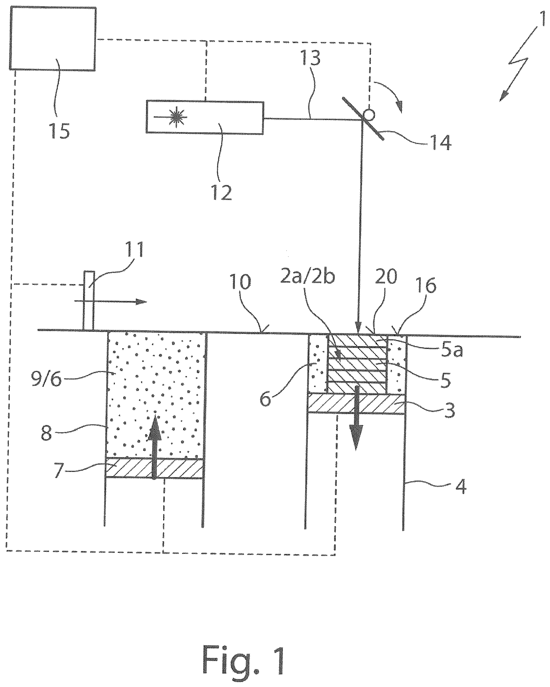

Die **Fig. 1** zeigt in einer schematischen, teilweise geschnittenen Ansicht eine Apparatur 1 zur schichtweisen Fertigung von ersten (Teil-)Strukturen 2a und/oder zweiten (Teil-)Strukturen 2b, hier mittels selektivem Laserschmelzen, im Rahmen der Erfindung. Mit der Apparatur 1 kann insbesondere nacheinander eine erste Struktur 2a und eine zweite Struktur 2b gefertigt werden, die sodann zu einer zumindest zweiteiligen (Gesamt-)Struktur zusammengesetzt werden können. Alternativ können auch zwei Apparaturen 1 eingesetzt werden, wobei eine erste der Apparaturen 1 die erste Struktur 2a (oder erste Strukturen 2a) und eine zweite der Apparaturen 1 die zweite Struktur 2b (oder zweite Strukturen 2b) fertigt.

Die Apparatur 1 weist eine Bauplattform 3 auf, die in einer Führung 4 vertikal verfahrbar ist. Auf der Bauplattform 3 ist eine teilweise gefertigte Struktur 2a, 2b angeordnet, von der bereits einige Schichten 5 gefertigt sind.

Weiterhin ist ein Vorratsgefäß 9 mit Pulver (pulverförmigem Material) 6 vorgesehen, wobei ein Pulverboden 7 in einer Führung 8 vertikal verfahrbar ist. Durch Hochfahren des Pulverbodens 7 gelangt eine kleine Menge pulverförmigen Materials 6 über das Niveau eines Apparaturbodens 10, so dass dieses pulverförmige Material 6 über einen horizontal verfahrbaren Schieber 11 zur Bauplattform 3 verbracht werden. Im gezeigten Beispiel ist das pulverförmige Material 6 ein Gemisch aus elementarem Titan und elementarem Niob oder ein Cu-Pulver.

Weiterhin ist ein Laser 12 vorgesehen, dessen Laserstrahl 13 der über ein dreh- und/oder verfahrbares Spiegelsystem 14 auf die gesamte Fläche der Bauplattform 3 gerichtet werden kann.

Der Laser 12 (bevorzugt auch dessen Leistung), das Spiegelsystem 14, der Schieber 11, die Bauplattform 3 und der Pulverboden 7 können über eine elektronische Steuereinrichtung 15 automatisch angesteuert werden. In der Steuerung sind CAD-Daten über die zu fertigende Struktur 2a, 2b enthalten.

Zum Fertigen einer neuen, oben liegenden Schicht 5a der Struktur 2a, 2b wird die Bauplattform 3 um eine Schichtdicke (meist ca. 25 µm-100 µm) abgesenkt, der Pulverboden 7 etwas nach oben gefahren und mit dem Schieber 11 pulverförmiges Material 6 über der Bauplattform 3 und der teilweise gefertigten Struktur 2a, 2b bis auf das Niveau des Apparaturbodens 10 aufgefüllt und glatt gestrichen. Der Laserstrahl 13 bzw. dessen Aufpunkt überstreicht sodann einen in dieser Schicht 5a vorgesehenen Bereich (bestrahlter Bereich) 20. Dort wird das pulverförmige Material 6 angeschmolzen und verfestigt. Üblicherweise herrscht zumindest um die oben liegende Schicht 5a eine Schutzgasatmosphäre (etwa N2 oder Ar oder Vakuum), um Oxidationsprozesse am heißen bzw. aufgeschmolzenen Material zu vermeiden. Im nicht bestrahlten Bereich 16 bleibt das pulverförmige Material 6 lose.

Die **Fig. 6** zeigt eine alternative Apparatur 1 zur schichtweisen Fertigung von ersten (Teil-)Strukturen 2a und/oder zweiten (Teil-)Strukturen 2b, hier mittels selektivem Elektronenstrahlschmelzen, im Rahmen der Erfindung. Diese Apparatur 1 entspricht weitgehend der Apparatur von Fig. 1, so dass hier nur die wesentlichen Unterscheide erläutert werden.

Mittels einer Elektronenkanone 12a wird ein Elektronenstrahl 13a erzeugt, der mittels eines Linsensystems 14a abgelenkt wird. Der Elektronenstrahl 13a rastert den in der oben liegenden Schicht 5a des Pulvers 6 vorgesehenen Bereich auf der Bauplattform 3 ab. Dazu wird die Elektronenkanone 12a (bevorzugt auch deren Leistung) und das Linsensystem 14a von der Steuereinrichtung 15 entsprechend automatisch angesteuert. Durch die Energie der Elektronen im Elektronenstrahl 13a wird im bestrahlten Bereich 20 das Pulver 6 angeschmolzen und verfestigt. Der Elektronenstrahl 13a propagiert unter Vakuum.

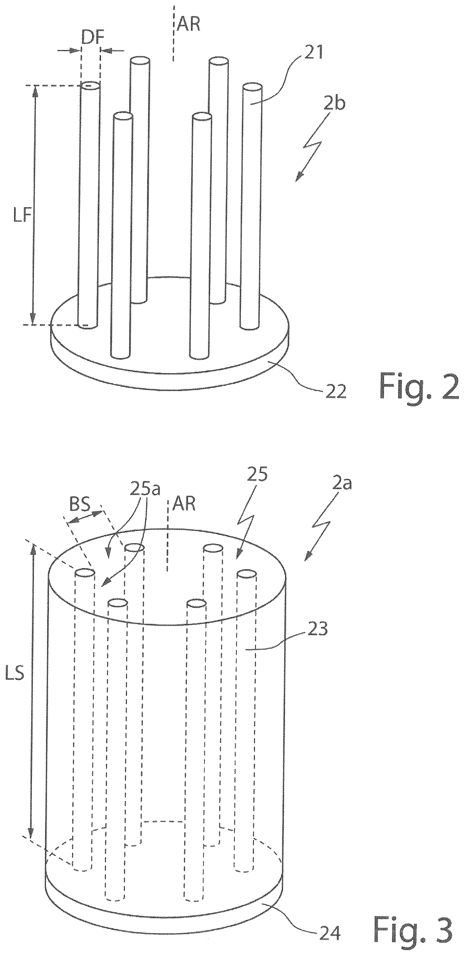

Die Fig. 2 zeigt beispielhaft eine zweite Struktur 2b, die im Rahmen der Erfindung gefertigt wurde, etwa auf einer Apparatur gemäß Fig. 1 oder Fig. 6.

Die zweite Struktur 2b umfasst eine Vielzahl (hier sechs) von axialen Fortsätzen 21, die sich in einer axialen Richtung (Längsrichtung, Erstreckungsrichtung) AR erstrecken. Die Fortsätze 21 sitzen auf einer Endplatte 22 auf, die typischerweise als Bauplatte (Substrat) während der schichtweisen Fertigung diente und die Fortsätze 21 mechanisch verbindet. Die Fortsätze 21 weisen eine axiale Länge LF auf und haben einen über die gesamte axiale Länge LF unveränderlichen, hier kreisförmigen Querschnitt. Der (größte) Durchmesser DF der Fortsätze 21 beträgt hier ca. 1/10 der Länge LF, so dass sich ein Fortsätze-Aspektverhältnis FAV von LF/DF=10 ergibt. Man beachte, dass bei vielen Anwendungen auch ein FAV von 20 oder mehr eingerichtet wird.

Fig. 3 zeigt beispielhaft eine erste Struktur 2a, die im Rahmen der Erfindung gefertigt wurde, etwa wiederum auf einer Apparatur gemäß Fig. 1 oder Fig. 6.

Die erste Struktur 2a ist hier im Wesentlichen kreiszylindrisch aufgebaut, wobei eine Vielzahl (hier sechs) von axialen Ausnehmungen 23 in der ersten Struktur 2a ausgebildet sind. Die erste Struktur 2a sitzt auf einer Endplatte 24 auf, die typischerweise als Bauplatte (Substrat) während der schichtweisen Fertigung diente. Die hier im Querschnitt kreisförmigen Ausnehmungen 23 sind voneinander getrennt, das heißt zwischen den Ausnehmungen 23 verbleibt ein axialer Stegebereich 25. Der Raum unmittelbar zwischen zwei benachbarten Ausnehmungen 23 kann auch als ein Steg 25a bezeichnet werden. Die Stege 25a haben eine axiale Länge LS und eine (kleinste) Breite BS; die (kleinste) Breite BS der Stege 25a kann auch als (kleinster) Abstand der Ausnehmungen 23 in Richtung quer zur axialen Richtung AR (Längsrichtung, Erstreckungsrichtung) bezeichnet werden. BS beträgt hier ca. 1/8 von LS, so dass sich ein Stege-Aspektverhältnis SAV von LS/BS=8 ergibt. Man beachte, dass bei vielen Anwendungen auch ein SAV von 20 oder mehr eingerichtet wird.

Die erste Struktur 2a ist komplementär zur zweiten Struktur 2b ausgebildet, so dass die Fortsätze 21 der zweiten Struktur 2b in die Ausnehmungen 23 der ersten Struktur 2a eingefügt werden können, insbesondere ohne dass nennenswerte Hohlräume über das für das Einfügen notwendige Spiel hinaus verbleiben, und insbesondere ohne dass die Endplatten 22, 24 entfernt zu werden bräuchten. Die Länge LF der axialen Forstätze 21entspricht dabei im Wesentlichen der Länge der axialen Ausnehmungen 23 bzw. der Länge LS der Stege 25a.

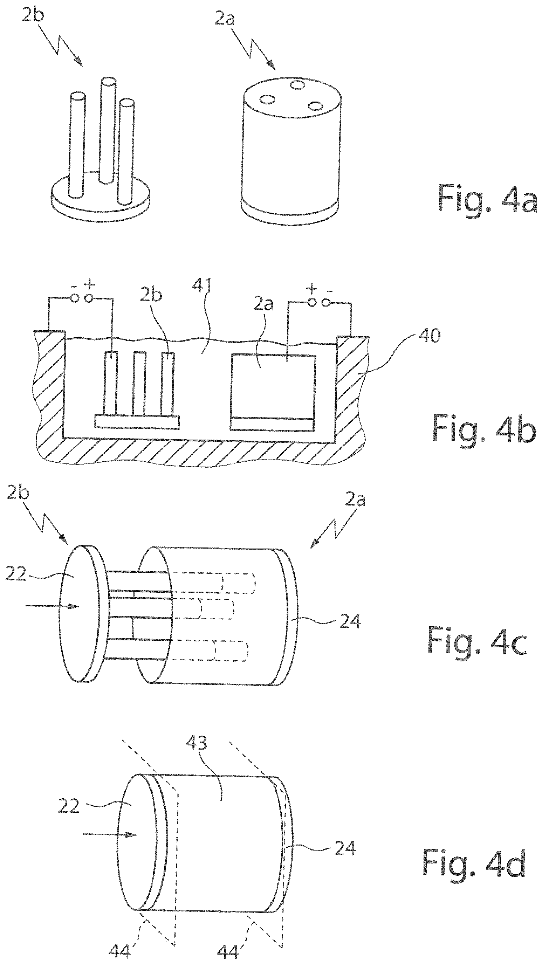

Die Figuren 4a bis 4f illustrieren die Fertigung einer erfindungsgemäßen zweiteiligen (Gesamt-)Struktur näher.

Fig. 4a zeigt zunächst beispielhaft eine erste Struktur 2a und eine komplementäre zweite Struktur 2b jeweils nach deren separater, schichtweiser Fertigung mittels Laserschmelzen oder Elektronenstrahlschmelzen, etwa in der Apparatur von Fig. 1 oder Fig. 6.

Um die Rauigkeit an der Oberfläche der ersten Struktur 2a und der zweiten Struktur 2b zu minimieren, werden die beiden Strukturen 2a, 2b sodann einer Oberflächenbehandlung unterzogen, hier einem Elektropolieren, vgl. Fig. 4b. Dazu wird eine elektrische Spannung zwischen der jeweiligen Struktur 2a, 2b und einem umgebenden Elektrolytbehälter 40 angelegt, wobei die Strukturen 2a, 2b als Anode geschaltet sind. Im Elektrolytbehälter 40 ist ein Elektrolyt 41 angeordnet (beispielsweise eine wässrige Lösung von Phosphorsäure und/oder Schwefelsäure). An Rauigkeitsspitzen herrscht eine besonders hohe elektrische Feldstärke, wodurch dort das Material der Strukturen 2a, 2b besonders schnell in Lösung geht, was die Rauigkeit reduziert. Man beachte, dass je nach Materialien der ersten und zweiten Struktur 2a, 2b auch unterschiedliche Elektrolyte 41 für die beiden Strukturen 2a, 2b eingesetzt werden können bzw. sollten, was dann typischerweise in getrennten Elektrolytbehältern stattfindet (nicht näher dargestellt). Gegebenenfalls kann im Rahmen des in Fig. 4b illustrierten Schritts auch eine andere und/oder weitere Oberflächenbehandlung wie eine Oberflächenbeschichtung, etwa Elektroplattieren oder eine Sprühbeschichtung, stattfinden (nicht näher dargestellt).

Die oberflächenbehandelten, beiden Strukturen 2a, 2b werden sodann ineinander gefügt, wie in **Fig. 4c** dargestellt. Zu diesem Zeitpunkt weisen die beiden Strukturen 2a, 2b typischerweise noch ihre Endplatten 22, 24 auf.

Nach dem Zusammenfügen liegt eine (hier) zweiteilige Struktur 43, auch bezeichnet als Gesamt-Struktur, vor, vgl. **Fig. 4d****.** Typischerweise werden sodann die Endplatten 22, 24 abgetrennt, vgl. die Schnittebenen 44, typischerweise mit einem möglichst kleinen Anteil weiteren Materials der Gesamt-Struktur 43. Die Abtrennung kann beispielsweise durch Sägen erfolgen.

Die dann vorliegende Gesamt-Struktur 43 weist stabförmige Unterstrukturen 45 (Filamente) des Materials der zweiten Struktur auf, und weiterhin eine umgebende Matrix 46 aus dem Material der ersten Struktur auf, vgl. **Fig. 4e****.**

In der Regel wird die Gesamt-Struktur 43 sodann einer querschnittsreduzierenden Umformung, etwa einem Extrudieren, unterworfen, vgl. **Fig. 4f****.**

Eine so erhaltene Gesamt-Struktur kann beispielsweise als Halbzeug für einen Supraleiterdraht dienen, typischerweise mit den stabförmigen Unterstrukturen aus einem Supraleitermaterial wie NbTi und einer Matrix aus einem normalleitenden, metallischen Material wie Cu.

Die **Fig. 5a** zeigt anhand einer ersten Struktur 2a und einer zweiten Struktur 2b die Orientierung der Schichten 5 bei einer schichtweisen Fertigung entlang der axialen Richtung (Erstreckungsrichtung) AR, vgl. die Fertigungsrichtung FR. Bei dieser Fertigungsrichtung FR liegen die nacheinander gefertigten Schichten 5 senkrecht zur axialen Richtung AR. Diese Fertigungsrichtung FR ist besonders für axial vergleichsweise lange Strukturen 2a, 2b geeignet und kostengünstig, da übliche Bauplattformen verwendet werden können.

Die Fig. 5b illustriert anhand einer ersten Struktur 2a und einer zweiten Struktur 2b die Orientierung der Schichten 5 bei einer schichtweisen Fertigung senkrecht zur axialen Richtung (Erstreckungsrichtung) AR, vgl. wiederum Fertigungsrichtung FR. Bei dieser Fertigungsrichtung FR liegen die nacheinander gefertigten Schichten 5 parallel zur axialen Richtung AR. Diese Fertigungsrichtung ermöglicht besonders hohe Stromtragfähigkeiten in axialer Richtung AR, etwa bei Supraleiterdrähten, benötigt aber große Bauplattformen.

### Bezugszeichenliste

- 1: Apparatur
- 2a: erste Struktur (Teilstruktur)
- 2b: zweite Struktur (Teilstruktur)
- 3: Bauplattform
- 4: Führung
- 5: Schicht
- 5a: oberste Schicht
- 6: Pulver/pulverförmiges Material
- 7: Pulverboden
- 8: Führung
- 9: Vorratsgefäß
- 10: Apparaturboden
- 11: Schieber
- 12: Laser (Laserquelle)
- 12a: Elektonenkanone
- 13: Laserstrahl
- 13a: Elektronenstrahl
- 14: Spiegelsystem
- 14a: Linsensystem
- 15: elektronische Steuerung
- 16: nicht bestrahlter Bereich
- 20: bestrahlter Bereich
- 21: axialer Fortsatz
- 22: Endplatte der zweiten Struktur
- 23: axiale Ausnehmung
- 24: Endplatte der ersten Struktur
- 25: Stegebereich
- 25a: Steg
- 40: Elektrolytbehälter
- 41: Elektrolyt
- 43: zumindest zweiteilige Struktur (Gesamt-Struktur)
- 44: Schnittebene
- 45: Unterstruktur (Filament)
- 46: Matrix
- AR: axiale Richtung (Längsrichtung, Erstreckungsrichtung)
- BS: Breite Steg
- DF: Durchmesser axialer Fortsatz
- FAV: Forstätze-Aspektverhältnis
- FR: Fertigungsrichtung
- LF: axiale Länge Fortsatz
- LS: axiale Länge Steg/Stegebereich
- SAV: Stege-Aspektverhältnis

## Patentansprüche

1. Verfahren zur Fertigung einer zumindest zweiteiligen Struktur (43), insbesondere eines Halbzeugs für einen Supraleiterdraht,
wobei eine erste Struktur (2a) und eine zweite Struktur (2b) separat gefertigt werden, und anschließend die erste Struktur (2a) und die zweite Struktur (2b) ineinander gefügt werden,
wobei die erste Struktur (2a) und die zweite Struktur (2b) jeweils schichtweise durch selektives Laserschmelzen oder selektives Elektronenstrahlschmelzen eines Pulvers (6) gefertigt werden,
**dadurch gekennzeichnet, dass** die erste Struktur (2a) mit einer Vielzahl von axialen Ausnehmungen (23) gefertigt wird, und die zweite Struktur (2b) mit einer Vielzahl von gegengleichen, axialen Fortsätzen (21) gefertigt wird.

2. Verfahren nach Anspruch 1, **dadurch gekennzeichnet, dass** die erste Struktur (2a) und die zweite Struktur (2b) aus unterschiedlichen Materialien gefertigt werden.

3. Verfahren nach einem der vorhergehenden Ansprüche, **dadurch gekennzeichnet, dass** die erste Struktur (2a) mit wenigstens 7, bevorzugt wenigstens 19, axialen Ausnehmungen (23) und die zweite Struktur (2b) mit wenigstens 7, bevorzugt wenigstens 19, gegengleichen, axialen Fortsätzen (21) gefertigt wird.

4. Verfahren nach einem der vorhergehenden Ansprüche, **dadurch gekennzeichnet, dass** die axialen Fortsätze (21) der zweiten Struktur (2b) ein Fortsätze-Aspektverhältnis FAV von wenigstens 20 aufweisen.

5. Verfahren nach einem der vorhergehenden Ansprüche, **dadurch gekennzeichnet, dass** ein axialer Stegebereich (25) der ersten Struktur (2a), in welchem die axialen Ausnehmungen (23) ausgebildet sind, ein Stege-Aspektverhältnis SAV von wenigstens 20 aufweist.

6. Verfahren nach einem der vorhergehenden Ansprüche, **dadurch gekennzeichnet, dass** die erste Struktur (2a) und die zweite Struktur (2b) schichtweise entlang einer Richtung (FR) senkrecht zur axialen Erstreckungsrichtung (AR) der axialen Ausnehmungen (23) und der axialen Fortsätze (21) gefertigt werden.

7. Verfahren nach einem der vorhergehenden Ansprüche, **dadurch gekennzeichnet, dass** die erste Struktur (2a) und die zweite Struktur (2b) schichtweise entlang der axialen Erstreckungsrichtung (AR) der axialen Ausnehmungen (23) und der axialen Fortsätze (21) gefertigt werden.

8. Verfahren nach einem der Ansprüche 1 bis 7, **dadurch gekennzeichnet, dass** die zweite Struktur (2b) ganz oder überwiegend aus einem supraleitenden Material, insbesondere aus NbTi, gefertigt wird.

9. Verfahren nach einem der Ansprüche 1 bis 7, **dadurch gekennzeichnet, dass** die zweite Struktur (2b) ganz oder überwiegend aus Aluminium oder Kupfer gefertigt wird.

10. Verfahren nach einem der Ansprüche 1 bis 9, **dadurch gekennzeichnet, dass** die erste Struktur (2a) ganz oder überwiegend aus Aluminium oder Kupfer gefertigt wird, oder dass die erste Struktur (2a) ganz oder überwiegend aus einer Legierung enthaltend Aluminium oder Kupfer gefertigt wird.

11. Verfahren nach einem der vorhergehenden Ansprüche, **dadurch gekennzeichnet, dass** die zweiteilige Struktur (43) nach dem ineinander Fügen einer querschnittsverjüngenden Umformung, insbesondere einem oder mehreren Kalt- und/oder Warmumformprozessen, unterzogen wird.

12. Verfahren nach einem der Ansprüche, **dadurch gekennzeichnet, dass** die erste Struktur (2a) und/oder die zweite Struktur (2b) nach dem schichtweisen Fertigen durch selektives Laserschmelzen oder Elektronenstrahlschmelzen einer Oberflächenbehandlung, insbesondere einer rauhigkeitsreduzierenden Oberflächenbehandlung, bevorzugt Elektropolieren, unterzogen wird.

13. Eine zumindest zweiteilige Struktur (43), insbesondere ein Halbzeug für einen Supraleiterdraht, gefertigt nach einem der vorhergehenden Ansprüche.

## Claims

1. A method for producing an at least two-part structure (43), in particular a semifinished product for a superconducting wire,
wherein a first structure (2a) and a second structure (2b) are separately produced, and the first structure (2a) and the second structure (2b) are then inserted into one another,
wherein the first structure (2a) and the second structure (2b) respectively are produced in layers by selective laser melting or selective electron beam melting of a powder (6),
**characterized in that** the first structure (2a) is produced with a plurality of axial recesses (23) and the second structure (2b) is produced with a plurality of diametrically opposed axial extensions (21).

2. The method as claimed in claim 1, **characterized in that** the first structure (2a) and the second structure (2b) are produced from different materials.

3. The method as claimed in one of the preceding claims, **characterized in that** the first structure (2a) is produced with at least 7, preferably at least 19, axial recesses (23) and the second structure (2b) is produced with at least 7, preferably at least 19, diametrically opposed axial extensions (21).

4. The method as claimed in one of the preceding claims, **characterized in that** the axial extensions (21) of the second structure (2b) have an extensions-aspect ratio FAV of at least 20.

5. The method as claimed in one of the preceding claims, **characterized in that** an axial webs area (25) of the first structure (2a) in which the axial recesses (23) are configured has a webs-aspect ratio SAV of at least 20.

6. The method as claimed in one of the preceding claims, **characterized in that** the first structure (2a) and the second structure (2b) are produced layered along a direction (FR) perpendicular to the direction of axial extension (AR) of the axial recesses (23) and the axial extensions (21).

7. The method as claimed in one of the preceding claims, **characterized in that** the first structure (2a) and the second structure (2b) are produced layered along the direction of axial extension (AR) of the axial recesses (23) and the axial extensions (21).

8. The method as claimed in one of claims 1 through 7, **characterized in that** the second structure (2b) is completely or primarily produced from a superconducting material, in particular NbTi.

9. The method as claimed in one of claims 1 through 7, **characterized in that** the second structure (2b) is completely or primarily produced from aluminum or copper.

10. The method as claimed in one of claims 1 through 9, **characterized in that** the first structure (2a) is completely or primarily produced from aluminum or copper, or that the first structure (2a) is completely or primarily produced from an alloy containing aluminum or copper.

11. The method as claimed in one of the preceding claims, **characterized in that** the two-part structure (43), after the two structures are inserted into each other, is subjected to deformation that narrows the cross-section, in particular one or a plurality of cold and/or hot deformation processes.

12. The method as claimed in one of the claims, **characterized in that** the first structure (2a) and/or the second structure (2b), after layered production by selective laser melting or electron beam melting, are subjected to a surface treatment, in particular roughness-reducing surface treatment, preferably electropolishing.

13. An at least two-part structure (43), in particular a semifinished product for a superconducting wire, produced as claimed in one of the preceding claims.

## Revendications

1. Procédé de fabrication d'une structure au moins en deux parties (43), en particulier d'un demi-produit pour un fil supraconducteur, dans lequel une première structure (2a) et une deuxième structure (2b) sont fabriquées séparément, et la première structure (2a) et la deuxième structure (2b) sont ensuite insérées l'une dans l'autre, dans lequel la première structure (2a) et la deuxième structure (2b) sont respectivement fabriquées par couches par fusion sélective au laser ou fusion sélective par faisceau d'électrons d'une poudre (6),
**caractérisé en ce que** la première structure (2a) est fabriquée avec une pluralité d'évidements axiaux (23) et la deuxième structure (2b) est fabriquée avec une pluralité de saillies axiales (21) diamétralement opposées.

2. Procédé selon la revendication 1, **caractérisé en ce que** la première structure (2a) et la deuxième structure (2b) sont fabriquées à partir de matériaux différents.

3. Procédé selon l'une des revendications précédentes, **caractérisé en ce que** la première structure (2a) est fabriquée avec au moins 7, de préférence au moins 19 évidements axiaux (23) et la deuxième structure (2b) est fabriquée avec au moins 7, de préférence au moins 19 saillies axiales (21) diamétralement opposées.

4. Procédé selon l'une des revendications précédentes, **caractérisé en ce que** les saillies axiales (21) de la deuxième structure (2b) présentent un rapport d'aspect des saillies FAV d'au moins 20.

5. Procédé selon l'une des revendications précédentes, **caractérisé en ce qu'**une zone à nervures axiale (25) de la première structure (2a), dans laquelle les évidements axiaux (23) sont formés, présente un rapport d'aspect des nervures SAV d'au moins 20.

6. Procédé selon l'une des revendications précédentes, **caractérisé en ce que** la première structure (2a) et la deuxième structure (2b) sont fabriquées par couches le long d'une direction (FR) perpendiculairement à la direction d'extension axiale (AR) des évidements axiaux (23) et des saillies axiales (21).

7. Procédé selon l'une des revendications précédentes, **caractérisé en ce que** la première structure (2a) et la deuxième structure (2b) sont fabriquées par couches le long de la direction d'extension axiale (AR) des évidements axiaux (23) et des saillies axiales (21).

8. Procédé selon l'une des revendications 1 à 7, **caractérisé en ce que** la deuxième structure (2b) est fabriquée entièrement ou principalement à partir d'un matériau supraconducteur, en particulier du NbTi.

9. Procédé selon l'une des revendications 1 à 7, **caractérisé en ce que** la deuxième structure (2b) est fabriquée entièrement ou principalement à partir d'aluminium ou de cuivre.

10. Procédé selon l'une des revendications 1 à 9, **caractérisé en ce que** la première structure (2a) est fabriquée entièrement ou principalement à partir d'aluminium ou de cuivre, ou **en ce que** la première structure (2a) est fabriquée entièrement ou principalement à partir d'un alliage contenant de l'aluminium ou du cuivre.

11. Procédé selon l'une des revendications précédentes, **caractérisé en ce que** la structure en deux parties (43), après l'insertion l'une dans l'autre, est soumise à un formage rétrécissant la section transversale, en particulier à un ou plusieurs processus de formage à froid et/ou à chaud.

12. Procédé selon l'une des revendications, **caractérisé en ce que** la première structure (2a) et/ou la deuxième structure (2b), après la fabrication par couches par fusion sélective au laser ou fusion sélective par faisceau d'électrons, sont soumises à un traitement de surface, en particulier à un traitement de surface réduisant la rugosité, de préférence un électropolissage.

13. Structure au moins en deux parties (43), en particulier demi-produit pour un fil supraconducteur, fabriquée selon l'une des revendications précédentes.
